## Europäisches Patentamt

## European Patent Office

## Office européen des brevets

(19)

(11) Veröffentlichungsnummer: **0 188 205**
**B1**

(12) **EUROPÄISCHE PATENTSCHRIFT**

(45) Veröffentlichungstag der Patentschrift:
**22.06.88**

(21) Anmeldenummer: **86100099.0**

(22) Anmeldetag: **07.01.86**

(51) Int. Cl.⁴: **G 03 C 1/68, G 03 F 7/10**

(54) **Polyamidester-Fotoresist-Formulierungen gesteigerter Empfindlichkeit.**

(30) Priorität: **15.01.85 DE 3501028**
**06.04.85 DE 3512544**

(43) Veröffentlichungstag der Anmeldung:
**23.07.86 Patentblatt 86/30**

(45) Bekanntmachung des Hinweises auf die Patenterteilung:
**22.06.88 Patentblatt 88/25**

(84) Benannte Vertragsstaaten:
**AT CH DE FR GB IT LI NL SE**

(56) Entgegenhaltungen:
**EP - A - 0 019 122**
**EP - A - 0 047 184**
**EP - A - 0 143 380**

**Die Akte enthält technische Angaben, die nach dem Eingang der Anmeldung eingereicht wurden und die nicht in dieser Patentschrift enthalten sind.**

(73) Patentinhaber: **Merck Patent Gesellschaft mit beschränkter Haftung, Frankfurter Strasse 250, D-6100 Darmstadt (DE)**

(72) Erfinder: **Merrem, Hans-Joachim, Dr., Donnersbergstrasse 6, D-6104 Seeheim (DE)**
Erfinder: **Klug, Rudolf, Dr., Grünewaldstrasse 25, D-8750 Aschaffenburg (DE)**
Erfinder: **Herold, Thomas, Dr., Bergweg 5, D-6101 Brensbach 4 (DE)**

## Beschreibung

Die Erfindung betrifft Fotoresist-Formulierungen zur Ausbildung von Reliefstrukturen aus hochwärmebeständigen Polyimid-Polymeren.

Derartige Fotoresist-Formulierungen sind begehrte und vielfältig eingesetzte Materialien bei der Herstellung fotopolymerisierter Beschichtungen sowie bei der fotolithographischen Erzeugung von fotopolymerisierten Reliefstrukturen. Hauptanwendungsgebiet hierbei ist die Herstellung mikroelektronischer und optoelektronischer Bauelemente und Schaltungen, wobei solche Materialien als Fotoresist bei der Erzeugung der Schaltungsstrukturen oder in diesen als in besonderem Masse hitze- und chemikalienbeständige Schutz- oder Passivierungsschichten, als Isolationsschichten, Dielektrika oder bei Flüssigkristallanzeigezellen als Orientierungsschichten Verwendung finden. Weitere Anwendungen sind die Verwendung als Fotoresist, als Ätz- una Galvanoresist sowie als Lötstoplack bei der Herstellung von gedruckten Schaltungen sowie von Druckplatten und sonstigen reprographischen Materialien.

In den deutschen Patentschriften DE-PS 2 308 830 und DE-PS 2 437 348 sind Verfahren zur Herstellung von Beschichtungen und Reliefstrukturen beschrieben, bei denen man Fotoresistformulierungen auf Basis fotopolymerisierbare Reste tragender Polyamidester-Präpolymere bildmässig belichtet, unbelichtete Anteile mit einem Entwickler entfernt und daraufhin die erhaltenen Abbildungen tempert, wobei das die Reliefstruktur bildende Präpolymer in ein hochwärmebeständiges Polyimid-Polymer überführt wird.

Diese ursprünglichen Systeme besassen jedoch nur mässige Empfindlichkeit, wobei für eine ausreichende Fotovernetzung und die Gewährleistung einer für die Mikroelektronik erforderlichen Auflösung und Kantensteilheit der Reliefstrukturen mit den üblichen Strahlungsquellen Belichtungszeiten von mindestens etwa 3 Minuten erforderlich waren. Bei Schichtdicken bis etwa 5 µm, wobei für diesen Bereich ein in etwa linearer Zusammenhang zwischen Schichtdicke und erforderlicher Mindestbelichtungsenergie angenommen werden kann, bedeutet dies Mindestbelichtungsenergien von 500 - 1000 mJ/cm² · µm. Mittlerweile erfuhren diese Fotoresistsysteme vielfältige Weiterentwicklungen und Verbesserungen, insbesondere im Hinblick auf Steigerung der Empfindlichkeit, um durch kürzere Belichtungszeiten auch eine hohe Wirtschaftlichkeit in der Anwendung zu erzielen.

So werden den Zusammensetzungen empfindlichkeitssteigernde Zusätze zugefügt, wie etwa Fotoinitiatoren und Fotosensibilisatoren sowie strahlungsreaktive copolymerisierbare ungesättigte Verbindungen, gegebenfalls in Kombination miteinander.

So wird z.B gemäss DE-PS 2 919 841 eine Steigerung der Empfindlichkeit durch en Zusatz von Fotoinitiatoren vom Typ der N-Azidosulfonylarylmaleinimide erreicht. Ebenfalls ist dies gemäss EP-OS 47 184 durch den Zusatz von Bisimidazol-Fotoinitiatoren möglich. Mindestbelichtungszeiten um 60 Sekunden (entsprechen ca. 200 - 300 mJ/cm²·µm

Mindestbelichtungsenergie) sind erforderlich, um kantenscharfe Reliefstrukturen mit einer Auflösung von ca. 3 µm zu erhalten. In der US-PS 4 329 419 wird vorgeschlagen, Fotoresistformulierungen auf Basis fotopolymerisierbarer Polyamidester-Präpolymere eine polyfunktionelle Acrylatverbindung, einen aromatischen Bisimidazol-Fotoinitiator sowie einen Leucofarbstoff zuzusetzen. Dieser Patentschrift ist zu entnehmen, dass die besten erzielbaren Mindestbelichtungsenergie bei 40 - 120 mJ/cm²·µm liegen. Die europäische Patentanmeldung EP 0 119 162 beschreibt Fotoresistmaterialien, die neben fotopolymerisierbaren Polyamidesterpräpolymeren Metallocene als Fotoinitiatoren und gegebenenfalss copolymeriserbare Acrylat- bzw. Allylverbindungen enthalten. Hier liegen die günstigsten Werte für die Mindestbelichtungsenergien bei 30 - 50 mJ/cm²·µm. Gemäss der deutschen Patentanmeldung P 3 342 851 wird eine Reduktion der Mindestbelichtungsenergie von Polyamidesterfotoresist-Formulierungen auf Werte von 25 - 40 mJ/cm²·µm durch den Zusatz strahlungreaktiver copolymerisierbarer Vinyl- oder Allylverbindungen sowie Fotoinitiatoren vom Typ der N-Azidosulfonylarymaleinimide erreicht.

Dennoch entspricht die Empfindlichkeit derartiger Fotoresistsysteme noch nicht den heutigen, weiter gestiegenen Erfordernissen für eine rationelle und wirtschaftliche Produktion von mikroelektonischen Bauelementen und Schaltungen. Es ist wünschenswert, die erforderlichen Mindestbelichtungsenergien bzw. -zeiten für derartige Systeme noch weiter zu reduzieren.

Es wurde nun gefunden, dass sich überraschenderweise eine Steigerung der Empfindlichkeit derartiger Fotoresistsysteme auf Werte bis unter 10 mJ/cm²·µm erreichen lässt, wenn diese als Fotoinitiator eine Verbindung vom Typ der N-Azidosulfonylarylmaleinimide und einen Leucofarbstoff vom Typ der Triarylmethane enthalten.

Gegenstand der Erfindung sind somit Fotoresistformulierungen zur Ausbildung von Reliefstrukturen aus hochwärmebeständigen Polyimid-Polymeren enthaltend in einem organischem Lösungsmittel im wesentlichen mindestens je

a) ein fotopolymeriserbare Reste tragendes Polyamidesterpräpolymer

b) eine strahlungsreaktive copolymerisierbare ungesättigte Verbindung

c) einen Fotosensibilisator

d) einen Fotoinitiator

e) einen Leucofabstoff vom Typ der Triarylmethane, wobei der Fotoinitiator eine Verbindung vom Typ der N-Azidosulfonylarylmaleinimide ist.

Gegenstand der Erfindung ist weiterhin ein Verfahren zur Herstellung von Reliefstrukturen aus hochwärmebeständigen Polyimid-Polymeren durch Beschichten eines Substrates mit einer Fotoresistformulierung, Trocknen der Schicht, bildmässiges Belichten der Schicht und Ablösen der nicht bestrahlten Schichtteile sowie Tempern der erhaltenen Reliefstrukturen, wobei eine Fotoresistformulierung gemäss der Erfindung verwendet wird.

Die fotopolymerisierbare Reste tragenden Polyamidester-Präpolymere die das Grundmaterial der erfindungsgemässen Fotoresistformulierungen bilden, sind aus den eingangs zitierten Patentschriften bekannt. Dort sind als für Fotolacke geeignete strahlungsreaktive lösliche Polymere Polyadditions- oder Polykondensationsprodukte polyfunktioneller carbozyklischer oder heterozyklischer, strahlungsreaktive Reste tragender Verbindungen mit Diaminen, Diisocyananten, Bis-Säurechloriden oder Dicarbonsäuren offenbart. Dort wie auch hier gelten als bevorzugt Polykondensate aus Pyromellitsäure, die zwei esterartig an Carboxylgruppen gebundene strahlungsreaktive Reste trägt, und einem mindestens ein zyklisches Strukturelement enthaltenden Diamin wie beispielsweise 4,4'-Diaminodiphenylether, 4,4'-Diaminodiphenylmethan, 4,4'-Diaminodiphenylsulfon, 2,4-Diaminopyridin. Die vielfältigen strahlungsreaktiven Reste, die diese löslichen polymeren Vorstufen enthalten können, sind ebenfalls diesen Druckschriften zu entnehmen. Es sind dies insbesondere esterartig an Carboxylgruppen gebundene strahlungsreaktive Oxyallyl-, Oxyalkylacrylat- und Oxyalkylmethacrylatgruppen wie etwa 2-Oxyethylacrylat- oder -methacrylatgruppen ferner aber auch die in der Deutschen Offenlegungsschrift DE-OS 3 227 584 beschriebenen Allyloxy-und/oder Allylthiogruppen enthaltenden Estergruppen. Die in den erfindungsgemässen Fotoresistformulierungen enthaltenen löslichen polymeren Vorstufen haben in der Regel Molekulargewichte zwischen 2000 und 100 000 vorzugsweise zwischen 4000 und 60 000.

In einer besonders bevorzugten Ausführungsform der vorliegenden Erfindung ist das fotopolymerisierbare Polyamidester-Präpolymer ein Polykondensat von Pyromellitsäure, die zwei mit Hydroxyethylmethacrylat veresterte Carboxylgruppen aufweist, und 4,4'-Diaminodiphenylether.

Die in den erfindungsgemässen Fotoresistformulierungen enthaltenen strahlungsreaktiven copolymerisierbaren ungesättigten Verbindungen sind ebenfalls aus der Fotoresisttechnologie bekannt. Es sind dies mono-, di- oder polyfunktionelle Acryl- bzw. Allylverbindungen, insbesondere Acryl- und Allylester bzw. Acryl- und Allylether von aliphatischen, cycloaliphatischen oder auch aromatischen Polyhydroxyverbindungen. Derartige Verbindungen sind etwa der DE-OS 3 233 912, der EP-OS 0 119 162 und dem US-Patent 4 329 419 zu entnehmen. Aber auch die in der deutschen Patentanmeldung P 3 342 851 beschriebenen Vinylsulfonverbindungen sind vorzüglich geeignet.

Als Beispiele copolymerisierbarer Verbindungen seien genannt: Vinylverbindungen wie 2-Hydroxyethylvinylether und 2-Hydroxyethylvinylsulfon; Acrylverbindungen wie Trimethylolpropantriacrylat bzw. -trimethacrylat, ethoxyliertes Trimethylolpropantriacrylat, Pentaerythrittriacrylat bzw. -trimethacrylat; Mono- und Diacrylate bzw. -methacrylate von Ethylenglycol oder Di-, Tri- und Tetraethylenglycol wie etwa Ethylenglycolmonoacrylat, Triethylenglycoldimethacrylat, Tetraethlenglycolomonoacrylat, Tetraethlenglycoldimethacrylat; Allylether wie Trimethylolpropantriallylether und Pentaerytrittriallylether.

Als weitere Komponente enthalten die erfindungsgemässen Fotoresistformulierungen mindestens einen Fotosensibilisator. Hierfür geeignete Verbindungen sind aus der Fotoresisttechnologie geläufig, beispielsweise 4,4'-Bis-(dimethylamino)-benzophenon (Michler's Keton), 4,4'-Bis-(diethylamino)-benzophenon, Benzoinether, Campherchinon, Anthrachinon- oder Thioxanthon-Derivate, ferner auch copolymerisierbare strahlungsempfindliche Maleinimide wie beispielsweise N-Phenylmaleinimid.

Entscheidend für die besonders hohe Strahlungsempfindlichkeit der erfindungsgemässen Fotoresistformulierungen sind die beiden weiteren Komponenten Fotoinitiator und Leucofarbstoff, die gemeinsam in der Fotoresistzusammensetzung vorliegen müssen.

Bei den den Fotolacken erfindungsgemäss zusammen mit einem Leucofarbstoff zur Verkürzung der Bestrahlungszeiten zuzusetzenden Fotoinitiatoren handelt es sich um Verbindungen vom Typ der N-azidosulfonylarylmaleinimide. Solche Verbindungen sowie ihre Verwendung als Fotoinitiatoren bei der Herstellung von Reliefstrukturen sind in den Patentschriften DE-PS 2 919 823 und DE-PS 2 919 841 beschrieben. Für den erfindungsgemässen Verwendungszweck sehr gut geeignet sind die Verbindungen N-(4-Azidosulfonylphenyl)-maleinimid, 2-(N-Maleinimido)-naphtyl-5-sulfonylazid, 2-(N-Maleinimido)-naphtyl-6,8-bisulfonylazid. Besonders bevorzugt ist die Verbindung N-(4-Azidosulfonylphenyl)-maleinimid.

Die erfindungsgemäss einzusetzenden Leucofarbstoffe sind Verbindungen vom Typ der Triarylmethane. Diese Verbindungen leiten sich als sogenannte «Leuco-Basen» von der allgemeinen Klasse der Triphenylmethan-Farbstoffe ab. Sie sind weitgehend farblos, können aber leicht durch oxidative Prozesse, beispielsweise fotochemisch induzierte Oxidationen, in die farbigen Triphenylmethanfarbstoffe überführt werden.

Im Prinzip sind für den vorgesehenen Verwendungszweck die Leuco-Basen aller bekannten und gängigen Triphenylmethanfarbstoffe geeignet, da diese in den vorliegenden Fotoresist-Formulierungen weitgehend gleiche Sensibilisierungseigeschaften zeigen.

Vornehmlich werden aber Triphenylmethanderivate, in denen die Phenylreste in 4-Stellung durch alkylsubstituierte Aminogruppen, vorzugsweise Dialkylaminogruppen, substituiert sind, eingesetzt. Alkyl bedeutet hierbei normalerweise jeweils eine Alkylgruppe mit 1-6 C-Atomen. Die Phenylreste können weiterhin durch eine oder mehrer Alkylsubstituenten, vornehmlich Methyl, oder andere, bei Triphenylmethanfarbstoffen übliche Substituenten wie Halogen oder Carboxyl modifiziert sein. Weiterhin eignen sich auch die bekannten Abwandlungsprodukte derartiger Leuco-Basen, wie entsprechend substituierte Triphenylcarbinole oder lactonisierte Triphenylcarbinole. Beispiele für erfindungsgemäss einzusetzende Leucofarbstoffe sind etwa Tris-(4-dimethylaminophenyl)-methan, Tris-(4-dimethylaminophenyl)-methan, Tris-(4-diethylamino-o-tolyl)-methan, Tris-(4-diethylamino-o-tolyl)-methan, Tris-(4-dihexylaminophenyl)-methan, Tris-(4-dihexylamino-o-tolyl)-methan und 2-Carboxyl-4-dimethyl-aminophenyl-bis-(4-dimethylaminophenyl)-carbinol-Lacton. Bevorzugt sind Tris-(4-dimethylaminophenyl)-methan und Tris-(4-diethylamino-o-tolyl)-methan und 2-Carboxy-4-dimethylaminophenyl-bis-(4-dimethylaminophenyl)-carbinol-Lacton.

Es zeigte sich, dass der Empfindlichkeitssteigerung der Polyamidester-Fotolacke durch den erfindungsgemässen Zusatz von N-Azidosulfonylarylmaleinimid-Fotoinitiator und Triarylmethan-Leucofarbstoff offenbar ein unerwarteter synergistischer Effekt zugrunde liegt. Hierbei wird wohl während des Belichtungsvorganges zusätzliche Strahlungsenergie durch den Leucofarbstoff auf den Fotoinitiator übertragen, wodurch eine intensivere Ausnutzung der eingestrahlten Energiemenge und somit eine Beschleunigung des Belichtungsvorganges der Fotoresistbeschichtung erreicht wird. Ein derartiger Effekt konnte den bekannten Resistsystemen, in denen schon derartige Leucofarbstoffe aber andere Initiatoren (etwa in US-PS 4 329 419) eingesetzt wurden, nicht entnommen werden.

Zusätzlich zeigt der Gehalt an Leucofarbstoff noch den allerdings schon bekannten vorteilhaften Effekt, dass durch fotochemisch induzierte Farbstoffbildung das latente Bild in der belichteten Fotoresistschicht sofort, also noch vor der Entwicklung, sichtbar wird.

In den erfindungsgemässen Fotoresistformulierungen liegen in der Regel der Fotoinitiator in einem Anteil von 1 - 15 Gew.-%, vorzugsweise 2 - 10 Gew.-%, der Leucofarbstoff in einem Anteil von 0,1 - 5 Gew.-%, vorzugsweise 0,5 - 2,5 Gew.-%, bezogen auf die Gewichtsmenge an Polyamidester-Präpolymer vor. An copolymerisierbaren ungesättigten Verbindungen enthalten die Zusammensetzungen 5 - 35 Gew.-%, vorzugsweise 10 - 30 Gew.-%, an Fotosensibilisator enthalten sie 1 - 15 Gew.-%, vorzugsweise 2 - 10 Gew.-%, jeweils bezogen auf die Menge an Präpolymer.

Die Herstellung der erfindungsgemässen Fotoresistformulierungen erfolgt in an sich bekannter Weise durch Lösen der einzelnen Komponenten bzw. Mischen mit einem geeigneten, in dieser Technologie gängigen Lösungsmittel. Als Lösungsmittel, die sich für die genannten Bestandteile der Fotolacke eignen, sind beispielsweise Ethylenglycol, Glycolether wie Glycolmonomethylether, Glycoldimethylether und Glycolmonoethylether, aliphatische Ester wie Ethylacetat, Hydroxyethylacetat, Alkoxyethylacetat, n-Butylacetat oder Amylacetat, Ether wie Dioxan, Ketone wie Methylethylketon, Methyl-iso-butylketon, Cyclopentanon und Cyclohexanon, Dimethylformamid, Dimethylacetamid, Hexamethylphosphorsäuretriamid, N-Methylpyrrolidon, Butyrolacton, Tetrahydrofuran und Mischungen solcher Lösungsmittel zu nennen. Die einsatzbereiten Fotoresist-Formulierungen enthalten in der Regel 1 - 60 Gew.-%, vorzugsweise 5 - 50 Gew.-%, an in derartigen Lösungsmitteln gelösten Komponenten.

Weiterhin können die erfindungsgemässen Fotoresistformulierungen noch zusätzlich in der Technologie der Fotoresists übliche Zusätze und Hilfsstoffe enthalten, etwa Farbstoffe, Pigmente, Weichmacher, Haftvermittler wie beispielsweise Vinylsilane, thermisch aktivierbare, freie Radikale bildende Initiatoren, ferner auch die verschiedensten anderen Polymere und Harze, Stabilisatoren sowie oberflächenaktive Verbindungen, die gegebenfalls zur Verbesserung der filmbildenden oder Beschichtungseigenschaften und/oder zur Verbesserung der Haftung der auf die Substrate aufgetragenen Schichten, zur Verbesserung der mechanischen Festigkeit, der chemischen Widerstandsfähigkeit, der Fliessbeständigkeit des Materials, aber auch zur Beeinflussung der Viskosität der Fotolacke beitragen können. Solche Zusatzstoffe können in einer Menge von 0,1 - 15 Gew.-%, bezogen auf den Gesamtgehalt an gelösten Komponenten, zugesetzt werden.

Die erfindungsgemässen Fotoresist-Formulierungen können in üblicher Weise auf prinzipiell alle beliebigen Substrate aufgebracht werden. Ihrem vornehmlichen Verwendungszweck entsprechend, nämlich der fotolithographischen Herstellung von Leiter- und Halbleiterschaltungen werden sie jedoch in erster Linie zur Beschichtung in dieser Technologie üblicher Substrate eingesetzt. Es sind dies überwiegend Siliziummaterialien, die rein oder durch Oxidation, Dotierung, Metall-, Halbleiter- oder Isolatorbeschichtung sowie Ätzung oberflächlich modifiziert sein können. Weiterhin kommen in Frage aus der Flüssigkristalldisplayherstellung bekannte Substrate wie Glas bzw. oberflächlich modifizierte oder beschichtete Glasmaterialien.

Die Fotolackschichten können in verschiedener Stärke auf ein Substrat aufgetragen werden. Die im Einzelfalle vorteilhafteste Schichtstärke hängt von verschiedenen Faktoren ab, insbesondere vom Bestimmungszweck der herzustellenden Beschichtung. Als zweckmässig hat sich in der Regel erwiesen, wenn die Resistschichten eine Stärke von 0,1 μm bis 200 μm aufweisen. Üblicherweise liegen bei der Halbleiterfertigung die Schichtstärken der Fotoresistbeschichtungen zwischen 0,5 und 10 μm, vorzugsweise zwischen 1 und 3 μm.

Der Auftrag der Fotoresistbeschichtungen auf die saubere Oberfläche der Substrate erfolgt nach üblichen Techniken, wie etwa Aufsprühen, Fliessbeschichten, Walzen, Schleuderbeschichten und Tauchbeschichten, wonach das Lösungsmittel durch Verdampfen entfernt wird, so dass auf der Oberfläche des Substrats eine strahlungsempfindliche Fotoresistschicht zurück bleibt. Die Entferunng des Lösungsmittels kann gegebenenfalls durch Erhitzen der Schicht auf Temperaturen von bis zu 120°C gefördert werden. Anschliessend wird die Fotolackschicht der Strahlung ausgesetzt, welche die Reaktion der strahlungsreaktiven Bestandteile unter Vernetzung der Schicht verursacht. Üblicherweise wird aktinisches Licht verwendet, aber auch energiereiche Strahlung wie Röntgen- oder Elektronenstrahlung kann verwendet werden. Die Bestrahlung oder Belichtung kann durch eine Maskenvorlage durchgeführt werden, es kann aber auch ein gebündelter Strahl der Strahlung über die Oberfläche der strahlungsempfindlichen Schicht geführt werden. Üblicherweise werden zur Bestrahlung UV-Lampen verwendet, die Strahlung einer Wellenlänge von 200 - 500 nm in einer Intesität von 0,5 - 60 mW/cm² aussenden. Gängige Strahlungsquellen haben eine Intensität von 5 - 6 mW/cm².

Die durch den erfindungsgemässen Zusatz von N-Azidosulfonylarylmaleinimid-Fotoinitiatoren und Triarylmethan-Leucofarbstoffen in ihrer Lichtempfindlichkeit gesteigerten Fotoresistformulierungen erlauben eine Reduktion der notwendigen Mindestbelichtungsenergie generell auf Werte zwischen 10 und 20 mJ/cm$^2 \cdot \mu$m, in günstigen Fällen sogar auf Werte unter 10 mJ/cm$^2 \cdot \mu$m. Dies entspricht bei Schichtdicken von 1 - 3 $\mu$m und einer Strahlungsleistung der Lichtquelle von 5 mW/cm$^2$ in etwa einer Mindestbelichtungszeit von 1,5 - 10 Sekunden. Eine durch eine derartige Empfindlichkeitssteigerung zu ermöglichende Verkürzung der Belichtungszeit bedeutet einen erheblichen Fortschritt für die Anwendung dieser Polyamidester-Fotoresists in der Halbleitertechnik.

Nach der Belichtung kann nun ein Bildmuster unter Freilegung von Teilen des Substrates entwickelt werden, indem die Schicht mit einer Entwicklerlösung behandelt wird, die die nicht bestrahlten Bereiche der Fotoresistschicht entfernt. Als Entwicklerlösung wird in der Regel ein Gemisch aus einem oder mehreren der für die Herstellung des Fotolacks bekannten Lösungsmittel mit einem Fällungsmittel verwendet. Typische Entwicklerlösungen sind beispielsweise 4-Butyrolacton/Toluol, Dimethylformamid/Ethanol, Dimethylformamid/Methanol, Methylethylketon/Ethanol und Methyl-i-butylketon/i--Propanol, jeweils im Verhältnis 2 : 1 bis 1 : 4. Besonders günstig für die Entwicklung von Reliefbildern aus den erfindungsgemässen Fotoresistformulierungen ist eine Entwicklerflüssigkeit die gemäss der Deutschen Offenlegungsschrift DE-OS 3 246 403 nur aus einem aliphatischen Keton, vorzugsweise Cyclopentanon, besteht. Nach Entwickeln, Waschen und Trocknen werden kantenscharfe Resistbilder mit einer Auflösung von unter 3 $\mu$m erhalten. Durch Tempern bei 200 - 400°C können diese in hochwärmebeständige Polyimid-Polymere überführt werden, die ausgezeichnete chemische, elektrische und mechanische Eigenschaften aufweisen.

Gemäss der Erfindung können somit der Fachwelt qualitativ besonders hochwertige Fotoresist-Materialien angeboten werden die, darüber hinaus eine besonders wirtschaftliche Anwendung ermöglichen.

*Beispiel 1*

a) Fotoresist aus

5 g Polyamidester-Präpolymer (erhalten durch Umsetzung von Pyromellitsäuredianhydrid mit 2-Hydroxyethylmethacrylat und anschliessend mit Thionylchlorid und 4,4'-Diaminodiphenylether gemäss DE-PS 2 437 348)
1,5 g 2-Hydroxyethylvinylsulfon
0,4 g N-(4-Azidosulfonylphenyl)-maleinimid
0,125 g 4,4'-Bis-(dimethylamino)-benzophenon
0,05 g Tris-(4-dimethylaminophenyl)-methan
0,05 g Vinyltrimethoxysilan
gelöst in 12 g Dimethylformamid

b) Anwendung

Die Fotoresist-Formulierung wird auf einen Siliziumwafer aufgeschleudert und durch Erwärmen getrocknet. Die erhaltene 1,5 $\mu$m starke Schicht wird mit einer Quecksilberhochdrucklampe mit einer Intensität von 5 mW/cm$^2$ für 5 Sekunden durch eine Fotomaske bestrahlt. Dies entspricht einer Belichtungsenergie von 17 mJ/cm$^2 \cdot \mu$m. Anschliessend werden die nicht bestrahlten Fotolackanteile durch Entwickeln mit einer Mischung aus 50 Gewichtsanteilen $\gamma$-Butyrolacton und 50 Gewichtsteilen Toluol ausgewaschen. Man erhält ein kantenscharfes Bild mit einer Auflösung von besser als 3 $\mu$m.

*Beispiel 2* (Vergleichsbeispiel)

a) Fotoresist

wie unter Beispiel 1, jedoch ohne Tris-4-(dimethylaminophenyl)-methan

b) Anwendung

Unter den gleichen Anwendungsbedingungen wie in Beispiel 1 beträgt die notwendige Belichtungszeit 8 Sekunden, was einer Mindestbelichtungsenergie von 27 mJ/cm$^2 \cdot \mu$m entspricht.

Die in den nachfolgenden Beispielen aufgeführten Fotoresist-Formulierungen sind wie unter Beispiel 1 zusammengesetzt, jedoch wurden anstelle von 2-Hydroxyethylvinylsulfon andere copolymerisierbare Verbindungen eingesetzt. Die Empfindlichkeit wird als gut bezeichnet, wenn die Belichtungszeit unter den Anwendungsbedingungen wie in Beispiel 1 weniger als 8 Sekunden beträgt.

*Beispiel 3*

1,0 g Trimethylolpropantriacrylat
Empfindlichkeit: gut

*Beispiel 4*

1,0 g ethoxyliertes Trimethylpropantriacrylat
Empfindlichkeit: gut

*Beispiel 5*

1,0 g Tetraethylenglykoldimethacrylat
Empfindlichkeit: gut

*Beispiel 6*

1,0 g Triethylenglykoldimethacrylat
Empfindlichkeit: gut

*Beispiel 7*

a) Fotoresist aus

5 g Polyamidester-Präpolymer (erhalten durch Umsetzung von Pyromellitsäuredianhydrid mit 2-Hydroxyethylmethacrylat und anschliessend mit Thionylchlorid und 4,4'-Diaminodiphenylether gemäss DE-PS 2 437 348)
1 g Tetraethlenglycoldiacrylat
0,25 g N-(4-Azidosulfonylphenyl)-maleinimid
0,125 g 4-4'-Bis-(dietylamino)-benzophenon
0,05 g Tris-(4-dimethylaminophenyl)-methan
0,05 g Vinyltrimethoxysilan
gelöst in 8 ml N-Methylpyrrolidon/Cyclopentanon
1 : 1

b) Anwendung

Unter den gleichen Anwendungsbedingungen wie in Beispiel 1 beträgt die notwendige Mindestbelichtungsenerige 12 mJ/cm$^2 \cdot \mu$m.

*Beispiel 8*

a) Fotoresist

wie in Beispiel 7, jedoch mit Tetraethylenglycolmonoacrylat als copolymerisierbare Verbindung

b) Anwendung

Unter den gleichen Anwendungsbedingungen wie in Beispiel 1 beträgt die notwendige Mindestbelichtungsenergie 8 mJ/cm$^2 \cdot \mu$m.

**Patentansprüche**

1. Fotoresist-Formulierungen zur Ausbildung von Reliefstrukturen aus hochwärmebeständigen Polyimid-Polymeren, enthaltend in einem organischen Lösungsmittel im wesentlichen midestens je

a) ein fotopolymerisierbare Reste tragendes Polyamidester-Präpolymer

b) eine strahlungsreaktive copolymeriserbare ungesättigte Verbindung

c) einen Fotosensibilisator

d) einen Fotoinitiator

e) einen Leucofarbstoff vom Typ der Triarylmethane dadurch gekennzeichnet, dass der Fotoinitiator eine Verbindung vom Typ der N-Azidosulfonylarylmaleinimide ist.

2. Verfahren zur Herstellung von Reliefstrukturen aus hochwärmebeständigen Polyimid-Polymeren durch Beschichten eines Substrates mit einer Fotoresist-Formulierung, Trocknen der Schicht, bildmässiges Belichten der Schicht und Ablösen der nicht bestrahlten Schichtteile sowie Tempern der erhaltenen Reliefstrukturen, dadurch gekennzeichnet, dass eine Fotoresist-Formulierung nach Anspruch 1 verwendet wird.

**Claims**

1. Photoresist formulations for forming relief structures of highly heat-resistant polyimide polymers, containing in an organic solvent in essence at least

a) one polyamide ester prepolymer carrying photopolymerisable radicals

b) a radiation-reactive copolymerisable unsaturated compound

c) a photosensitiser

d) a photoinitiator

e) a leuco dye of the type of the triarylmethanes characterised in that the photoinitiator is a compound of the type of the N-azidosulphonylarylmaleimides.

2. Process for preparing relief structures of highly heat-resistant polyimide polymers by coating a substrate with a photoresist formulation, drying the coat, subjecting the coat to imagewise exposure, detaching the non-irradiated parts of the ocat and heat-treating the resulting relief structures, characterised in that a photoresit formulation according to Claim 1 is used.

**Revendications**

1. Compostions de photoréserve pour la formation de structures en relief consistant en polymères de polyimides à haute stabilité à la chaleur, qui contiennent essentiellement, dans un solvant organique,

a) au moins un prépolymère de polyamide-ester portant des groupes photopolymérisables,

b) au moins un composé insaturé copolymérisable réactif aux rayonnements,

c) au moins un photosensibilisant,

d) au moins un photo-inducteur,

e) au moins un leuco d'un colorant du type des triarylméthanes, caractérisées en ce que le photoinducteur est un composé du type des N-azidosulfonylarylmaléimides.

2. Procédé de préparation de structures en relief consistant en polymères de polyimides à haute stabilité à la chaleur par application en revêtement sur un support d'une composition de photoréserve, séchage de la couche, exposition de la couche à la lumière avec formation d'une image et élimination des parties de la couche non éclairées puis traitement à la chaleur des structures en relief obtenues, caractérisé en ce que l'on utilise une composition de photoréserve selon la revendication 1.